# FASCICULE DE BREVET EUROPEEN

(11) **EP 1 385 683 B1**
(45) Date de publication et mention de la délivrance du brevet: **31.08.2005**
(21) Numéro de dépôt: 02732797.2
(22) Date de dépôt: 10.04.2002
(51) Int. Cl.: B28D 5/00, H01L 21/00, B32B 35/00

(54) **DISPOSITIF DE COUPE DE COUCHE D'UN SUBSTRAT, ET PROCEDE ASSOCIE**
SUBSTRATSCHICHTSCHNEIDVORRICHTUNG UND DAMIT VERBUNDENES VERFAHREN
SUBSTRATE- LAYER CUTTING DEVICE AND METHOD ASSOCIATED THEREWITH

(30) Priorité: 10.04.2001 FR 0104937; 29.10.2001 FR 0113951
(43) Date de publication de la demande: 04.02.2004
(73) Titulaire: S.O.I.Tec Silicon on Insulator Technologies, 38190 Bernin (FR)
(72) Inventeur: MARTINEZ, Muriel, F-38120 Saint Egrève (FR); BARGE, Thierry, F-38000 Grenoble (FR); SOUBIE, Alain, F-38120 Saint Egrève (FR); LAGAHE - Blanchard , Chrystelle, F-38134 Saint Joseph de Riviere (FR)
(74) Mandataire: Le Forestier, Eric
(86) Numéro de dépôt international: PCT/FR2002/001253
(87) Numéro de publication internationale: WO 2002/083387

(56) Documents cités:
- EP-A- 0 867 917
- EP-A- 0 977 242
- WO-A-01/10644
- US-A- 6 050 255

## Description

La présente invention concerne de manière générale le traitement des matériaux, et plus particulièrement de substrats pour l'électronique, l'optique ou l'optroélectronique.

Plus précisément, l'invention concerne un dispositif de coupe automatique de haute précision d'une couche de matériau qui est solidaire d'un substrat source par l'intermédiaire d'une zone fragilisée, le substrat source et la couche à couper formant un ensemble à couper, le dispositif comprenant des moyens de coupe ainsi que des moyens de maintien de la position de l'ensemble à couper.

On précise que par « coupe » on entend dans ce texte l'opération consistant à diviser en deux parties disjointes un même élément ou ensemble, et à garantir que lesdites parties ne se réunissent pas à nouveau.

Comme on va le voir, une telle coupe est dans le cadre de l'invention réalisée au niveau d'une zone fragilisée.

Et l'invention concerne également un procédé de coupe automatique de haute précision d'une couche de matériau qui est solidaire d'un substrat source par l'intermédiaire d'une zone fragilisée, le substrat source et la couche à couper formant un ensemble à couper, le procédé comprenant :
- le positionnement de l'ensemble à couper par rapport à des moyens de maintien,
- la coupe de la couche par des moyens de coupe.

On précise que l'invention est particulièrement adaptée à la coupe de couches, dont l'épaisseur est inférieure à une centaine de microns, et en particulier à la coupe de couches dites "minces", dont l'épaisseur est de l'ordre du micron.

Des dispositifs et procédés tels qu'évoqués ci-dessus sont utilisés pour constituer des couches (minces ou non), qui peuvent être destinées à être transférées du substrat source auquel elles ont été prélevées vers un support dit « support cible ».

Les substrats se présentent généralement sous la forme de disques appelés « wafers » selon la terminologie anglo-saxonne répandue. Les wafers peuvent être réalisés dans un matériau semiconducteur tel que le silicium.

Il est connu de constituer à l'intérieur d'un wafer une zone fragilisée selon un plan parallèle aux faces principales du wafer.

La zone fragilisée peut être réalisée par implantation d'ions bombardés sur la surface du wafer, ces ions créant dans le volume du wafer une couche fragilisée délimitant une région supérieure (qui correspond dans le cadre de ce texte au substrat source) et une région inférieure adjacente à la source d'ions (qui correspond dans le cadre de ce texte à la couche qui sera coupée).

On trouvera dans le document FR 2 681 472 un exemple d'un tel procédé, qui permet de réaliser des couches minces. Le document WO-A-01/10644 décrit un dispositif selon le préambule de la revendication 1 et un procédé selon le préambule de la revendication 20.

Il est également possible de réaliser la zone fragilisée par tout autre moyen connu en soi, par exemple en construisant une région intermédiaire de matériau poreux entre deux régions de matériau dense, en constituant une couche d'oxyde enterrée dans un substrat (par exemple un substrat de type SOI (Silicon On Insulator selon la terminologie anglo-saxonne répandue), ou encore en effectuant un collage de deux couches, la zone de collage correspondant à la zone fragilisée.

Pour réaliser la coupe au niveau de la zone fragilisée et constituer avec le substrat source et la couche à couper deux éléments disjoints, il est possible de faire appel à un opérateur manuel.

Mais le recours à un opérateur manuel constitue un facteur limitant pour la cadence de production des couches.

De plus, dans ce cas la reproductibilité des opérations n'est pas garantie.

On connaît également des dispositifs et procédés de coupe automatique, qui visent à s'affranchir des inconvénients précités.

Un exemple d'un tel dispositif et procédé est divulgué dans le document EP 925 888.

Le dispositif de ce document utilise l'impact d'un jet d'eau sur la tranche d'un wafer qui est par ailleurs maintenus sur ses deux faces principales, pour attaquer une zone fragilisée et diviser le wafer en deux parties.

Mais un tel dispositif reste de conception et de fonctionnement relativement complexe. En particulier, il nécessite de prévoir des disposition spécifiques pour que les moyens de maintien associés aux deux faces respectives du wafer autorisent un certain écartement des deux parties du wafer.

De plus, les moyens de maintien doivent également mettre le wafer en rotation pour que la totalité de la périphérie de celui-ci soit attaquée par le jet d'eau, ce qui complexifie encore la conception et le fonctionnement du dispositif.

Le document EP 989 593 divulgue également un dispositif et un procédé de coupe de couche.

Mais ici encore, il est nécessaire de prévoir un arrangement complexe, en particulier pour maintenir les deux parties du wafer que l'on veut diviser.

Un but de l'invention est de s'affranchir des inconvénients mentionnés ci-dessus en permettant de réaliser la coupe de couches, en particulier de couches minces, de manière particulièrement fiable et simple.

Un autre but de l'invention est de permettre en outre de réaliser une telle coupe sans endommager les surfaces respectives de la couche coupée et du substrat auquel la couche est reliée par l'intermédiaire de la zone fragilisée.

Un autre but de l'invention est de permettre en outre de contrôler finement les paramètres de l'opération de coupe, pour prévenir l'endommagement des wafers et adapter la cinématique de cette opération à différents types de wafer.

Afin d'atteindre ces buts, l'invention propose selon un premier aspect le dispositif de coupe automatique défini dans le revendication 1.

Des aspects préférés, mais non limitatifs du dispositif selon l'invention sont les suivants :
- les moyens de maintien comprennent une cale,
- la cale est fixe,
- la lame est mobile,
- les moyens de maintien sont disposés de manière à recevoir en butée un côté de l'ensemble à couper qui est généralement opposé au côté de l'ensemble à couper qui est attaqué par la lame,
- les moyens de maintien consistent en un ensemble de cale,
- les moyens de maintien consistent en une cale unique.
- la lame est associée à des moyens de réglage de position de lame selon la direction perpendiculaire au plan de coupe, permettant de positionner la lame à proximité de la zone fragilisée de l'ensemble à couper,
- la lame est montée sur des moyens de déplacement automatique,
- lesdits moyens de déplacement automatique assurent une translation contrôlée de la lame dans le plan de coupe,
- ladite translation contrôlée est une translation uniforme,
- le bord d'attaque de la lame a un contour circulaire correspondant au contour de l'ensemble à couper,
- le bord d'attaque de la lame couvre le quart de la périphérie de l'ensemble à couper,
- les moyens de coupe comprennent un premier moyen de coupe, et un deuxième moyen de coupe,
- le dispositif comprend également un capteur apte à acquérir un paramètre représentatif du déroulement de la coupe par le premier moyen de coupe, et des moyens pour déclencher la mise en oeuvre du deuxième moyen de coupe lorsque ledit paramètre atteint une valeur prédéterminée,
- ledit paramètre est lié à une mesure de l'écartement entre les parties du wafer à couper,
- le premier moyen de coupe comprend une lame et le deuxième moyen de coupe comprend deux lames agencées symétriquement par rapport à l'ensemble à couper,
- chaque lame du deuxième moyen de coupe est montée à déplacement sur des moyens de déplacement et le bord d'attaque de chaque lame est orienté de manière à attaquer l'ensemble à couper tangentiellement sur une portion de sa périphérie.

Selon un deuxième aspect, l'invention propose également le procédé de coupe automatique selon la revendication 20.

Des aspects préférés, mais non limitatifs du procédé selon l'invention sont les suivants :
- le procédé comprend l'engagement de la lame dans une encoche de l'ensemble à couper, ladite encoche se trouvant à proximité de la zone fragilisée,
- ladite encoche est une encoche de forme générale annulaire,
- le procédé comprend l'auto-ajustement, selon la direction perpendiculaire au plan de coupe, des positions relatives de l'ensemble à couper et de la lame lors de l'engagement de la lame et de l'ensemble à couper, par coopération du bord d'attaque de la lame et de la section concave de l'encoche,
- on suit l'onde de décollement de la couche à couper par analyse de la lumière transmise au travers des faces principales de l'ensemble à couper,
- les mouvements des moyens de déplacement de la lame sont asservis à l'observation du décollement de la couche à couper.
- les mouvements des moyens de déplacement de la lame sont asservis à des mesures d'efforts reçus par un élément mobile qui attaque l'ensemble à couper,
- on recueille au moins un paramètre représentatif du déroulement de la coupe lors d'une première phase de coupe réalisée par un premier moyen de coupe, et on commande en fonction de la valeur de ce paramètre le déclenchement d'une deuxième phase de coupe réalisée par un deuxième moyen de coupe,
- le premier moyen de coupe est une lame attaquant l'ensemble à couper en un premier endroit, et le deuxième moyen de coupe attaque l'ensemble à couper à distance de la partie dudit ensemble recevant l'attaque du premier moyen de coupe,
- le deuxième moyen de coupe comprend deux lames situées de part et d'autre de l'ensemble à couper, et déplacées symétriquement par rapport à cet ensemble.

D'autres aspects, buts et avantages de l'invention apparaîtront mieux à la lecture suivante d'une forme de réalisation de l'invention, faite à titre d'exemple non limitatif en référence aux dessins annexés sur lesquels :
- la figure 1 est une vue schématique en élévation de dessus d'ensemble d'un premier mode de réalisation d'un dispositif de coupe selon l'invention, sur laquelle est défini le plan de section II-II,
- les figures 2a et 2b sont deux vues schématiques en section selon le plan II-II d'un wafer comportant une zone fragilisée, positionné dans un dispositif de coupe tel que celui de la figure 1,
- la figure 3 est une représentation schématique agrandie en élévation de côté d'une lame d'un dispositif tel que celui de la figure 1 lors de son attaque d'un wafer en vue d'en découper une couche,
- la figure 4 est une vue schématique agrandie en élévation de dessus d'un bord de lame d'un dispositif tel que celui de la figure 1, à proximité de la zone d'attaque du wafer
- les figures 5a et 5b sont respectivement une vue de dessus et une vue de côté correspondante d'un second mode de réalisation d'un dispositif de coupe selon l'invention, comprenant des moyens perfectionnés de coupe qui sont mis en oeuvre lors de deux phases successives,
- la figure 6 est une figure analogue à la représentation de la figure 3, qui illustre schématiquement les interfaces d'un wafer soumis à une opération de coupe,
- la figure 7 est une représentation schématique de dessus des moyens du dispositif des figures 5a et 5b qui permettent d'effectuer la coupe d'une couche de wafer dans une première position desdits moyens qui correspond à une première phase des opérations de coupe,
- la figure 8 est une représentation similaire à la représentation de la figure 7, dans laquelle les moyens de coupe ont une deuxième position correspondant à une deuxième phase des opérations de coupe,
- la figure 9 est une vue de détail de certains moyens de coupe du dispositif qui correspond à un deuxième mode de réalisation de l'invention,
- les figure 10a et 10b représentent en vue de dessus deux formes possibles des moyens de coupe de la figure 9,
- la figure 11 illustre schématiquement la pénétration d'une lame dans un wafer.

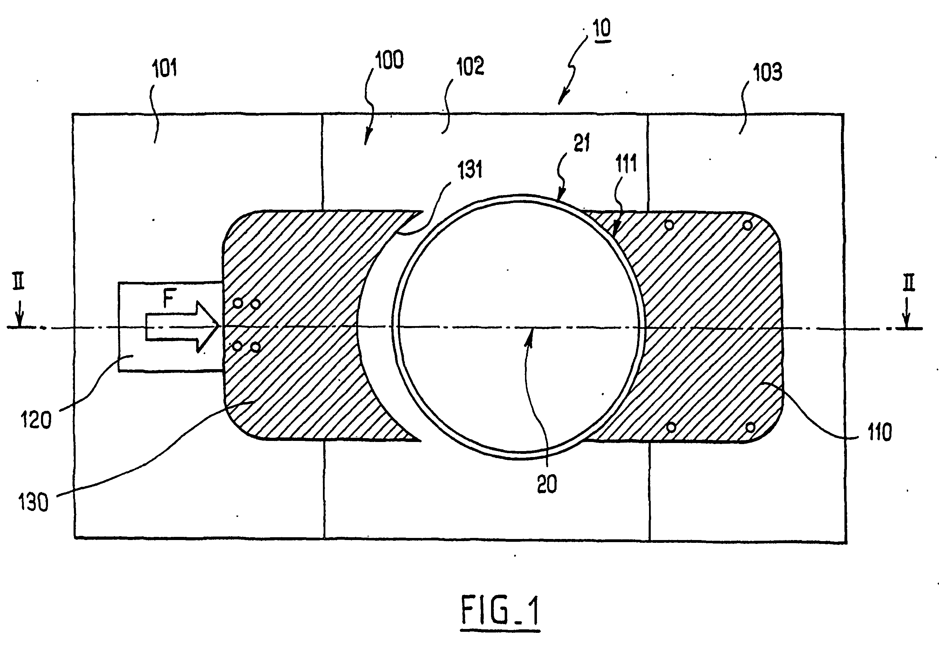

En référence tout d'abord à la figure 1, on a représenté un dispositif de coupe 10 selon un premier mode de réalisation de l'invention, avec un wafer 20. Le wafer constitue un ensemble à couper.

Le dispositif 10 est destiné à couper une couche du wafer selon un plan de coupe parallèle aux faces du wafer (c'est à dire parallèle au plan de la figure 1, que l'on définit comme le plan horizontal). La couche sera ainsi coupée du substrat source, qui constitue le reste du wafer 20.

On précise que par convention la vue de la figure 1 est dite vue de dessus, et on se référera pour l'ensemble de cette description à la direction verticale comme étant la direction perpendiculaire au plan moyen du wafer.

Le wafer 20 a une forme classique circulaire. Ce wafer comprend un substrat dit substrat source en un matériau semiconducteur tel que du silicium, ledit substrat comprenant lui-même une zone fragilisée telle qu'évoquée ci-dessus.

La zone fragilisée s'étend selon un plan intermédiaire du wafer parallèle aux faces principales de ce wafer.

Et la zone fragilisée définit dans le substrat une couche, qui est destinée à être prélevée du wafer (par exemple pour transférer cette couche sur un support cible).

A la périphérie du wafer, on a représenté par deux cercles concentriques un chanfrein annulaire 21 qui entoure le wafer.

Pour des raisons de clarté, l'écart entre les deux cercles qui figurent le chanfrein 21 a été exagérément grossi par rapport au diamètre du wafer.

Ce chanfrein est situé dans la paroi latérale du wafer, à distance des faces supérieure et inférieure dudit wafer. On reviendra dans la suite de ce texte sur ce chanfrein et sur son rôle.

Le wafer 20 est posé sur la partie centrale 102 d'un châssis fixe et plan 100, ledit châssis supportant également une cale 110 et un support de déplacement 120 d'une lame 130 fixée sur ce support de déplacement.

La cale 110 est fixée (par exemple par des vis) sur une partie d'extrémité 103 du châssis 100, ledit châssis 100 comprenant en réalité deux parties d'extrémité 101 et 103 qui entourent la partie centrale 102 qui est quant à elle amovible.

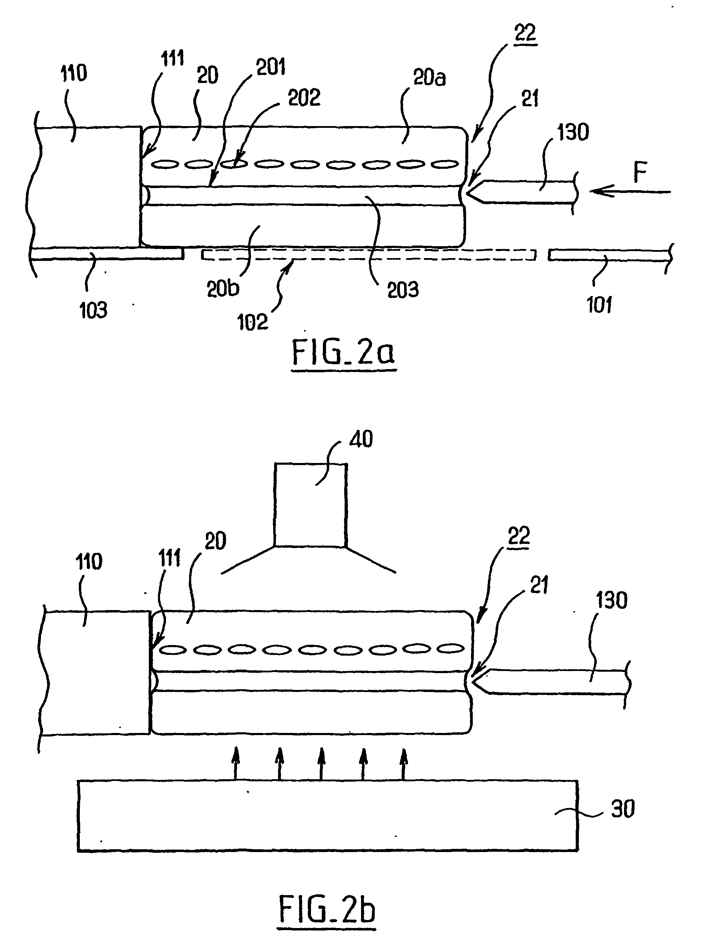

La cale 110 présente une section 111 qui est en contact avec la paroi latérale du wafer. La section 111 a une géométrie concave circulaire complémentaire de celle de la portion de wafer qu'elle reçoit. La section 111 est droite selon la direction verticale (comme cela apparaît clairement sur les figures 2a et 2b).

Cette section 111 peut également avoir toute autre géométrie dont la coopération de formes avec la paroi du wafer 20 autorise les mouvements de ce demier dans la direction verticale perpendiculaire au plan de coupe de la lame.

En particulier, cette section 111 pourra présenter une légère encoche ou saillie, afin de favoriser encore l'auto-ajustement de la position du wafer par rapport au dispositif (cet aspect d'auto-ajustement sera détaillé ci-dessous).

Sur l'exemple illustratif de la figure 1, la section 111 de la cale couvre ainsi un peu plus d'un quart de la périphérie du wafer. Dans une variante, cette section peut couvrir un quart de la périphérie du wafer. Et en tout état de cause, cette section doit couvrir une partie de la périphérie du wafer suffisante pour assurer le maintien du wafer soumis à l'attaque d'une lame (comme cela va être décrit).

Le wafer 20 a été amené en butée contre la section 111 droite de la cale, à la main ou bien par des moyens de manutention automatiques adaptés.

Le support de déplacement 120 est fixé sur la partie 101 du châssis fixe 100. Ce support porte par ailleurs la lame 130, pour déplacer ladite lame en translation vers le wafer (dans le sens de la flèche F).

La lame 130 comporte une section 131 destinée à attaquer le wafer - on appellera cette section 131 le bord d'attaque de la lame.

Le bord d'attaque 131 a comme la section 111 de la cale une géométrie concave circulaire. Cette géométrie circulaire est alors généralement complémentaire de celle de la portion de wafer que la lame doit attaquer. Typiquement, la lame attaque le wafer sur une partie qui représente environ un quart de la périphérie du wafer.

On précise toutefois que le bord d'attaque 131 n'est pas nécessairement circulaire, et peut avoir toute autre géométrie.

Le wafer 20 est intercalé entre la cale 110 et la lame 130 qui est montée sur le support de déplacement 120. Ces éléments sont alignés, la cale et la lame étant diamétralement opposés par rapport au centre du wafer et le déplacement de la lame se fait selon la direction F de cet alignement.

La lame est destinée à attaquer la paroi latérale du wafer à une hauteur désirée (la position de la lame pouvant par ailleurs être ajustée en hauteur pour attaquer ladite paroi à la hauteur désirée - cet ajustement peut par exemple être réalisé par des moyens de réglage de position de lame selon la direction perpendiculaire au plan de coupe).

Les moyens de déplacement 120 sont aptes à déplacer la lame jusqu'à amener son bord d'attaque 131 en contact avec la paroi latérale du wafer, et à pénétrer dans le wafer au-delà de ladite paroi sur une profondeur donnée.

Cette profondeur de pénétration peut être de l'ordre de un centimètre par exemple. Elle sera toutefois définie en fonction de paramètres tels que la forme de la section de la lame, ainsi que les caractéristiques du wafer (matériaux constituant le wafer, forme du chanfrein annulaire, ...).

On précise que si la profondeur de pénétration peut avoir une valeur allant jusqu'à environ un centimètre, la largeur de la zone de contact physique entre le wafer et lame ne doit pas dépasser quelques millimètres (correspondant à la largeur de la zone d'exclusion).

A cet égard, la forme de la lame peut être adaptée pour comporter par exemple :
- une pointe définie par deux faces pentues, destinée à pénétrer dans le wafer lors de la mise en contact initiale de la lame et du wafer, les faces pentues jouant le rôle d'un coin écartant l'une de l'autre les deux parties du wafer,
- ainsi qu'une portion d'épaisseur constante déterminée, située en arrière de la pointe, comme représenté sur la figure 11. Cette portion d'épaisseur constante est la seule partie de la lame à être en contact avec le wafer après que la pointe ait pénétré ledit wafer. Elle permet de maintenir entre les parties du wafer un écartement contrôlé correspondant à l'épaisseur prédéterminée de cette partie de lame, et favorise ainsi la coupe contrôlée du wafer. On précise à cet égard qu'il est important de limiter la dimension de la zone de contact physique entre la lame et le wafer, car la lame ne doit pas entrer en contact avec la zone centrale du wafer qui se trouve entourée par la zone d'exclusion (en vue de dessus du wafer), et qui correspond à la zone active du wafer qui sera effectivement utilisée. La figure 11 montre ainsi que la pointe de lame qui a pénétré entre les parties de wafer, n'est plus en contact physique avec le wafer, le contact entre la lame et le wafer étant limité à la portion de largeur d1 de la lame qui est d'épaisseur constante. Cette épaisseur constante de la portion arrière de la lame sera définie en fonction du type de wafer à couper ; à titre d'exemple, elle pourra être de l'ordre de 5 millimètres.

Le rôle de la lame est de couper, c'est à dire comme défini plus haut de diviser en deux parties disjointes le wafer (en l'occurrence les deux parties sont le substrat source et la couche que l'on désire prélever), et de garantir que lesdites parties ne se réunissent pas à nouveau suite à cette division.

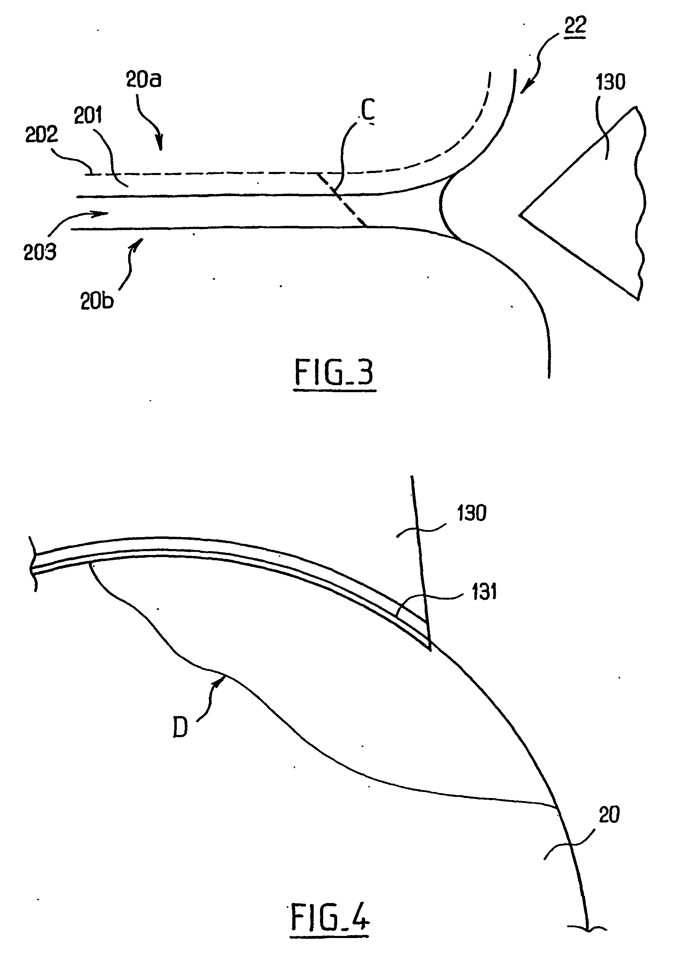

A cet effet, la lame a une section biseautée, comme représenté sur les figures 2a, 2b et 3.

Plus précisément, en référence à ces figures, une utilisation préférée du dispositif selon l'invention est illustrée.

On précise que ces figures schématiques sont présentées à titre purement illustratif, et que les échelles de grandeur entre les différents éléments représentés (couches du wafer, lame, autres éléments du dispositif selon l'invention..) ne sont nullement représentatives de la réalité.

On constate sur ces figures schématiques que la paroi latérale 22 du wafer 20 qui est représenté n'est pas complètement droite, mais qu'elle présente une encoche annulaire qui correspond au chanfrein 21.

Cette encoche annulaire est produite par la juxtaposition des bords arrondis de deux parties 20a et 20b du wafer, qui ont été liées par tout procédé connu en soi (collage ou autre) pour constituer ledit wafer 20. L'encoche annulaire 21 correspond à l'interface de collage 203 entre les deux parties 20a et 20b.

En effet, les wafers de semiconducteurs doivent selon les normes en vigueur présenter des bords non vifs, afin d'éviter leur endommagement lors d'un choc accidentel : les parties 20a et 20b (qui considérées indépendamment constituent elles-mêmes des « wafers ») respectent donc ces normes, et leurs bords sont arrondis ou chanfreinés.

Et le wafer représenté correspond à une utilisation préférée de l'invention, dans laquelle on coupe une couche mince 201 en attaquant le wafer avec la lame 130 à proximité d'une zone fragilisée 202.

Plus précisément, le wafer 20 illustré sur ces figures a été réalisé de manière à ce que l'interface de collage 203 entre les deux parties 20a et 20b à partir desquelles le wafer a été constitué se trouve a proximité immédiate de la zone fragilisée 202.

Et dans ce cas c'est de préférence au niveau de cette interface de collage à laquelle est associée une encoche annulaire 21 ayant une section concave formant chanfrein, que la pointe de la lame 130 doit attaquer le wafer 20.

En effet, selon un aspect avantageux de l'invention, lors de la progression en translation de la lame 130 selon la direction horizontale F la coopération des formes de la pointe de la lame (forme généralement convexe, par exemple en biseau) et de l'encoche annulaire en chanfrein (forme généralement concave) permet l'auto-ajustement de la position en hauteur du wafer par rapport à la lame.

En effet, lors de la coupe le wafer est libre selon la direction verticale.

On constate sur la figure 2a qu'aucun élément ne limite les mouvements du wafer vers le haut.

Et il en est de même des mouvements du wafer vers le bas : dès que la lame a commencé à attaquer la paroi du wafer, il est en effet prévu de retirer la partie de châssis horizontal 102 amovible, afin de laisser le wafer totalement libre selon la direction verticale.

De la sorte, dès que la lame a commencé à engager la paroi latérale du wafer à proximité immédiate de l'interface de collage 203, la coopération de formes évoquée plus haut provoque l'auto-ajustement de la position de la pointe de la lame en face du centre de ladite interface.

On précise qu'on a préalablement réglé la hauteur d'attaque initiale de la lame afin qu'elle se présente sensiblement face à cette interface.

En référence plus précisément à la figure 3, la lame 130 attaque donc initialement la paroi latérale du wafer à proximité immédiate de l'interface de collage 203, afin de provoquer la coopération de formes entre les pentes du biseau de la lame et celles de l'encoche annulaire du chanfrein 21.

On précise que l'épaisseur du bord d'attaque de la lame (c'est à dire l'épaisseur de la section terminale de ladite lame par le rayon de courbure de la pointe de la lame) est de l'ordre de la dizaine de microns, voire plus.

Quant à l'épaisseur de la lame elle-même, elle peut être de l'ordre de quelques millimètres.

Par ailleurs, la distance entre l'interface de collage 203 et la zone fragilisée 202 est très largement inférieure aux dimensions de la lame.

Ainsi lors de l'attaque de la lame dans la paroi latérale du wafer, la géométrie du biseau du bord d'attaque de la lame produit l'effet d'un coin qui écarte de part et d'autre les parties du wafer selon la direction verticale perpendiculaire au plan de coupe.

Et les contraintes verticales qui écartent les deux parties du wafer l'une de l'autre trouvent alors naturellement leur chemin vers la zone fragilisée 202 qu se trouve à proximité immédiate.

Ce transfert des contraintes verticales de la zone fragilisée 202, de la région située en regard de l'interface de collage 203 vers la zone fragilisée 202, est illustré sur la figure 3 par la ligne de contrainte C, qui représente de manière très schématique la ligne de coupe entre les deux parties du wafer à proximité du bord dudit wafer.

Lorsque cette ligne C a rejoint la zone fragilisée 202, et en poursuivant vers l'intérieur du wafer (c'est à dire vers la gauche de la figure 3), la ligne de coupe se confond avec la zone fraglisée 202.

En effet, cette zone 202 fragilisée représente un « puits » pour les contraintes, et le wafer étant libre selon la direction verticale l'auto-ajustement mentionné ci-dessus se poursuit pour permettre à la lame de poursuivre sa pénétration dans le wafer au niveau du chanfrein 21.

On a dit que la lame n'était en tout état de cause en contact avec le wafer que sur une profondeur limitée à l'intérieur du wafer. Cette profondeur, de l'ordre de quelques millimètres, correspond à la portion non active du wafer (« zone d'exclusion »).

A cet égard, la géométrie de la lame est telle que la lame ne joue pas le rôle d'un outil « tranchant » qui « découperait » le wafer (on a en effet défini ci-dessus la « coupe », qui ne correspond pas à un effet tranchant).

En réalité, l'angle interne du biseau de la lame, si il doit être assez faible pour que la lame pénètre effectivement dans le wafer, doit également être assez important pour que la lame joue effectivement son rôle de coin enfoncé entre la couche 201 que l'on désire transférer et le reste du wafer. En effet, une fois que la lame a commencé à pénétrer dans le wafer, les bords pentus de son bord d'attaque écartent selon la direction verticale la couche 201 et le reste du wafer. Cet angle pourra être de l'ordre de 60°.

Ceci permet la propagation de l'onde de décollement de la couche 201 sur une large partie, voire la totalité de la surface du wafer (alors que la lame ne pénètre que de d'une profondeur limitée dans le wafer).

On remarquera que le fait qu'aucun élément ne limite les mouvements du wafer selon la direction verticale, ni vers le haut ni vers le bas, permet au wafer non seulement de réaliser l'auto-ajustement de sa position selon la direction verticale de l'attaque de la lame, mais également de se déformer librement et de manière symétrique lors de cet écartement.

Ceci favorise le bon déroulement de la coupe, et diminue les risques de détérioration de la couche 201 et du substrat - en particulier lorsque le substrat 20b est réalisé dans un matériau fragile tel que le quartz.

La lame est réalisée dans un matériau lisse, assez dur pour pénétrer le wafer mais pas trop dur afin de ne pas risquer d'endommager les surfaces de la couche 201 et du substrat.

A titre d'exemple, la lame peut être réalisée dans un matériau tel que le Polychlorure de Vinyle (PVC), ou le Polyetheretherketone (PEEK), ou le Teflon (marque déposée).

Et l'épaisseur de la lame doit être suffisante pour maintenir la couche 201 suffisamment écartée du reste du wafer et garantir que l'onde de décollement de la couche 201 se propage effectivement sur la plus grande partie de la surface du wafer.

La Demanderesse a déterminé qu'une épaisseur de l'ordre de 5 millimètres était bien adaptée à cet effet.

La figure 4 montre l'onde de décollement D de la couche 201, observée à proximité du bord de la lame, pour le dispositif 10 qui correspond comme on l'a dit à un premier mode de réalisation de l'invention.

On peut définir l'onde de décollement comme le front que l'on observe lorsqu'on divise le wafer en deux parties, et qui matérialise la ligne selon laquelle la couche 201 se divise du reste du wafer.

La figure 2b représente à cet égard une variante avantageuse de l'invention, dans laquelle on visualise en permanence la progression de l'onde de décollement de la couche 201 grâce à une source lumineuse 30 (par exemple une lampe infra rouge) placée sous le wafer et dirigée vers celui-ci, et une caméra 40 située de l'autre côté du wafer pour recueillir la lumière transmise au travers du wafer.

La source lumineuse peut n'être amenée en regard du wafer qu'après l'escamotage de la partie centrale 102 du châssis fixe.

Il est également possible d'utiliser une partie 102 transparente au rayonnement issu de la source 30.

Et on remarquera que le fait qu'aucun élément de maintien ne soit placé en regard des faces principales du wafer permet d'observer cette onde de décollement dans d'excellentes conditions ; ceci n'est pas le cas dans les dispositifs automatiques de l'état de la technique, qui comprennent des moyens de maintien des faces principales du wafer.

Il est également possible d'asservir le mouvement du support de déplacement de lame 120 aux observations de la caméra 40, en prévoyant une boucle de régulation du déplacement permettant d'obtenir une progression contrôlée de l'onde de décollement.

On reviendra sur cet aspect de contrôle du déplacement des moyens de coupe du dispositif, dans la suite de ce texte, à propos d'un deuxième mode de réalisation de l'invention.

Il est également possible de programmer le support de déplacement pour assurer une translation continue de la lame. Ceci est particulièrement adapté lorsque le wafer a une structure simple.

Par contre, dans le cas d'un wafer constitué à partir d'un grand nombre de couches collées ensemble, il peut être préférable de faire progresser la lame de manière intermittente (les moyens de régulation évoqués ci-dessus seront ici encore mis en oeuvre avec profit).

Dans le cas d'un wafer réalisé sur un substrat inférieur 20b transparent (quartz par exemple), la caméra 40 peut être placée directement sous le wafer (à l'emplacement de la source 30 sur la figure 2b), et observer le décollement par transparence au travers du substrat inférieur.

La cale unique 110 peut être remplacée par un ensemble de cale comportant plusieurs cales fixes, bloquant le wafer dans le plan de coupe horizontal mais le laissant libre selon la direction verticale.

Dans le cas où on met en oeuvre l'invention sur un wafer ne comportant pas de chanfrein annulaire, on pourra ménager dans la paroi du wafer une encoche de section concave en regard de l'endroit où le bord d'attaque de la lame attaquera le wafer, afin d'obtenir la coopération de formes et l'auto-ajustement décrits ci-dessus.

Il est également possible de prévoir plusieurs lames, montées sur le même support de déplacement, ou montées sur des moyens de déplacements respectifs indépendants les uns des autres.

On détaillera également cet aspect à propos d'un deuxième mode de réalisation de l'invention.

Et les moyens de déplacement de la lame ou des lames peuvent dans une version simplifiée de l'invention être activés par des moyens manuels, tels qu'une manivelle.

On précise qu'en tout état de cause, on cherchera de préférence à générer une onde de décollement unique lors de l'attaque du wafer par la ou les lame(s).

En effet, la jonction de deux ondes différentes initiées en des endroits différents de la périphérie du wafer et se propageant dans des directions différentes peut s'avérer problématique.

Ainsi, dans le cas où plusieurs lames sont prévues, une configuration bien adaptée est celle dans laquelle une lame s'avance en pointe, les autres prenant le relais de l'attaque de la première lame en arrière de celle-ci et sur ses côtés, tout en contribuant à propager la même onde de décollement qui a été initiée par la première lame.

Il n'est toutefois pas obligatoire que l'attaque du wafer se fasse initialement au milieu de celui-ci (sur l'axe longitudinal du dispositif qui joint les centres de la lame et de la cale) ; la lame peut avoir un contour dissymétriques avec une pointe qui s'avance d'un côté seulement, et qui attaque en premier un côté du wafer.

Il est également possible que la lame soit fixe et que ce soit la cale qui soit mobile - en tout état de cause, seul un des deux éléments doit être mobile. Dans tous les cas, les dispositions relatives à l'auto-ajustement de la position du wafer évoquées ci-dessus seront mises en oeuvre avec profit.

Et il est possible d'associer à la lame un capteur de pression ou de force, afin de suivre les efforts reçus par la lame lors de la coupe.

On pourra alors effectuer une régulation de l'avance de la lame (ou de l'élément mobile) en fonction de ces efforts. Cette régulation peut être utilisée en combinaison avec la régulation en fonction de l'onde de décollement décrite ci-dessus, ou à titre de régulation alternative.

En référence maintenant aux figures 5a et 5b, 7, 8 et 10, on a représenté un dispositif 50 permettant de mettre en oeuvre l'invention selon un deuxième mode de réalisation.

Ce dispositif 50, comme le dispositif 10 décrit ci-dessus, est destiné à couper une tranche d'un wafer 20.

Sur la figure 5a qui est une représentation schématique de dessus, on a représenté autour du wafer 20, une cale 510 et une première lame 530 portée par des moyens de déplacement 520 pour être mobile par rapport à la cale, de manière similaire à la configuration du dispositif 10 décrit ci-dessus.

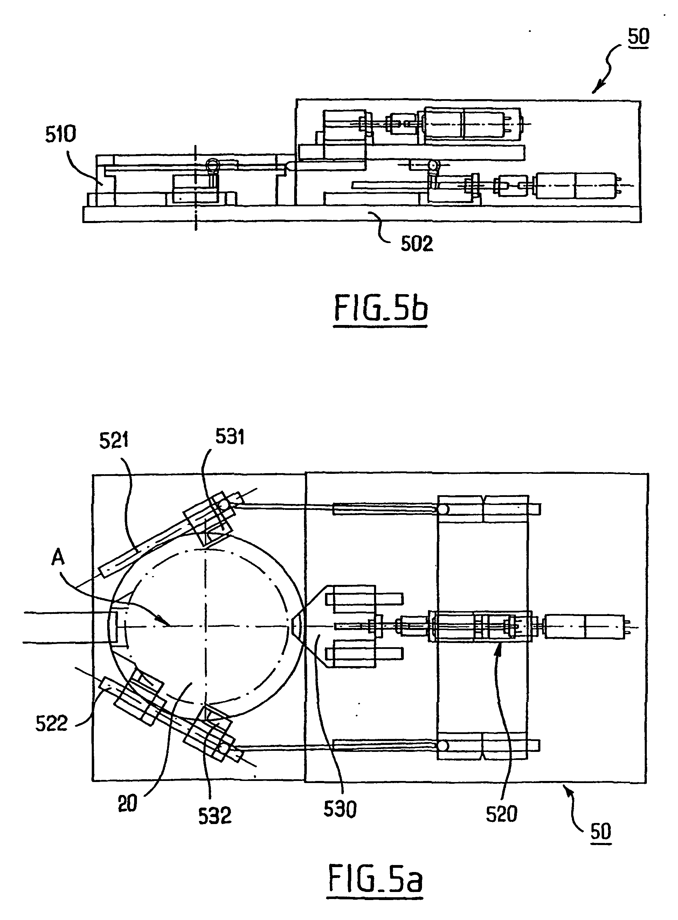

La cale 510 qui est représentée dans la partie gauche de la figure 5b est fixe, la lame 530 pouvant être rapprochée du wafer pour attaquer celui-ci.

Le wafer lui-même est de préférence disposé entre la cale 510 et la lame 530, de manière à ce que ces trois éléments soient alignés selon un axe qui correspond par ailleurs à la direction de déplacement de la lame 530.

On remarque sur la figure 5a que par rapport au dispositif 10 décrit ci-dessus, la lame 530 a une forme qui ne permet pas d'attaquer le wafer sur une partie importante de sa périphérie.

Au contraire, cette lame 530 a une géométrie vue de dessus en delta, dont une pointe est dirigée vers le wafer pour l'attaquer (la "pointe" du delta étant en réalité tronquée, de manière à présenter tout de même au wafer une section d'attaque selon une petite partie de sa périphérie).

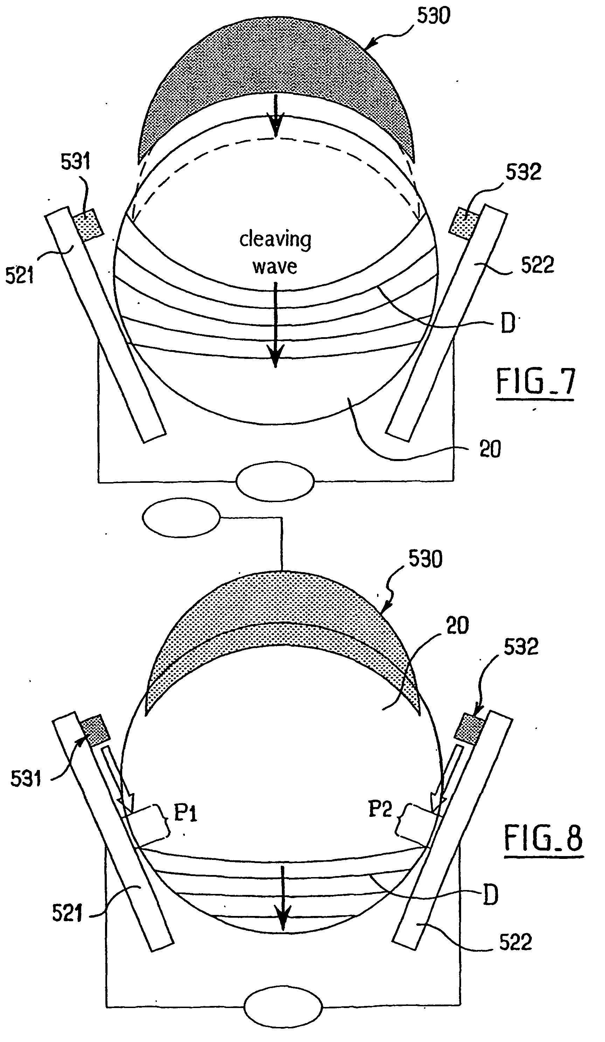

On verra en référence aux figures 7 et 8 que le bord d'attaque de cette première lame 530 peut également avoir une géométrie circulaire, comme dans le cas de la lame 130 du dispositif 10.

Selon un aspect particulier de ce deuxième mode de réalisation de l'invention, les moyens de coupe du dispositif 50 comprennent outre la première lame 530 qui constitue un premier moyen de coupe, un deuxième moyen de coupe.

Ce deuxième moyen de coupe est illustré par deux lames 531 et 532, qui sont disposées de part et d'autre de l'axe médian du wafer qui est parallèle à la direction de déplacement de la lame 530 (axe A représenté sur la figure 5a).

Chacune de ces lames 531, 532 est destinée à venir engager le wafer 20 dans une deuxième phase de l'opération de coupe, après l'engagement de ce wafer par la première lame 530 qui correspond à une première phase.

A cet effet, la lame 531 est portée par des moyens de déplacement 521, qui permettent de déplacer ladite lame selon une trajectoire lui permettant :
- d'attaquer le wafer 20 à distance de la partie recevant l'attaque de la première lame 530, d'un premier côté du wafer par rapport à la direction A d'attaque de la première lame,
- et éventuellement de poursuivre cette attaque sur la périphérie du wafer.

Et de manière symétrique par rapport à l'axe A, la deuxième lame 532 est portée par des moyens de déplacement 522.

Dans la représentation des figures 5a, 5b, 7 et 8, les deux moyens de déplacement 521 et 522 sont disposés de manière à déplacer les lames 531 et 532 selon deux sections de droites symétriques et convergentes vers l'axe longitudinal A médian du wafer.

Dans ce deuxième mode de réalisation de l'invention, le premier moyen de coupe (lame 530, ou tout ensemble de lame comportant au moins une lame) attaque le wafer 20 lors d'une première phase de coupe.

Un capteur suit la progression d'un paramètre représentatif de l'opération de coupe effectuée par la première lame 530.

Et c'est en fonction des signaux issus de ce capteur que la deuxième phase de coupe sera déclenchée automatiquement, par des moyens de commande adaptés.

La deuxième phase correspond à la mise en oeuvre du deuxième moyen de coupe (les deux lames 531 et 532 dans l'exemple illustré ici toutefois il est possible de réaliser le deuxième moyen de coupe sous la forme d'un ensemble comprenant un nombre quelconque de lames).

Ce n'est en effet qu'à partir d'une valeur prédéterminée dudit paramètre représentatif de l'opération de coupe effectuée par la première lame 530, valeur mémorisée dans les moyens de déclenchement de la deuxième phase de coupe, que le deuxième moyen de coupe est mis en oeuvre.

Ce paramètre représentatif de l'opération de coupe effectuée par la première lame 530 peut en particulier être lié à l'écartement observé entre les deux parties de wafer (ou être la valeur de l'écartement lui-même).

Dans ce cas, à partir d'un certain écartement entre les deux parties de wafer, le deuxième moyen de coupe est mis en oeuvre.

Il est également possible d'exploiter (alternativement, ou en addition) un autre paramètre représentatif de l'opération de coupe effectuée par la première lame 530 (évolution de l'onde de décollement par exemple).

On pourra ainsi en particulier mettre en oeuvre tout type de capteur optique, mécanique ou autre permettant de caractériser la progression du décollement provoquée par l'attaque du premier moyen de coupe, ou encore l'écartement entre la couche à couper et le reste du wafer.

Dans tous les cas, la deuxième phase ne sera déclenchée que lorsque le(s) paramètre(s) représentatif(s) de la progression de la coupe lors de la première phase aura (auront) atteint une (des) valeur(s) prédéterminée(s).

Dans le cas ou le capteur est une caméra, il peut s'agir d'une caméra infrarouge, située par exemple sous un hublot en quartz placé en dessous du wafer 20. Un tel hublot est représenté sur la figure 5b par la référence 502.

La caméra peut être également une caméra optique fonctionnant sur une longueur d'onde différente. Cette adaptation des caractéristiques de la caméra se fera en particulier en fonction de la nature du substrat source du wafer à partir duquel on prélève la couche à couper.

On peut en outre ici encore utiliser un capteur de force associé à la première lame 530, en combinaison avec le capteur évoqué ci-dessus.

Dans tous les cas, le capteur du ou des paramètre(s) représentatif(s) de la progression de la coupe lors de la première phase permet(tent) de déclencher la deuxième phase.

Et les signaux de ce(s) capteur(s) peuvent également être utilisés pour réguler la progression du deuxième moyen de coupe, lors de la deuxième phase.

On précise que lors de cette deuxième phase, le premier moyen de coupe peut être immobilisé, de manière à continuer à produire un effet de coin entre les parties du wafer qu'il a attaquées.
- Dans une variante, il est également possible de faire poursuivre au premier moyen de coupe son attaque du wafer pendant la deuxième phase de coupe - lors de cette phase les premier et deuxième moyens de coupe travailleront donc ensemble.

Dans un exemple préféré de réalisation de l'invention, il est ainsi possible de commander dans un premier temps le déplacement de la première lame 530, de sorte qu'elle soit seule à attaquer la paroi du wafer.

On précise que lors de cette première phase de coupe, on contrôle finement la vitesse de déplacement de la lame. Cette vitesse sera typiquement comprise en 0,5 et 5 mm/seconde.

Il est également possible de superposer au capteur qui déclenche la deuxième phase des moyens supplémentaires permettant de contrôler le bon déroulement de chaque phase de coupe.

On pourra ainsi adjoindre à l'attaque du wafer par la première lame qui correspond à la première phase, un système de mesure de force ou de vitesse de déplacement de la lame.

Dans ce cas, on pourra lors de la première phase ajuster continuellement la force avec laquelle la première lame attaque le wafer, et/ou sa vitesse de progression, pour effectuer cette première phase dans les meilleures conditions.

On pourra également utiliser les mesures du capteur qui déclenche la transition entre première et deuxième phase, pour commander finement le déplacement de chaque lame pendant la phase associée à ladite lame.

Le fait de mettre en oeuvre deux moyens de coupe séquentiellement, le passage du premier moyen au deuxième moyen étant commandé par une mesure représentative du déroulement de la coupe lors de la première phase, permet de faire progresser dans les meilleures conditions l'onde de décollement d'un bout à l'autre du wafer.

Ceci permet également de prévenir la formation de plusieurs ondes de décollement.

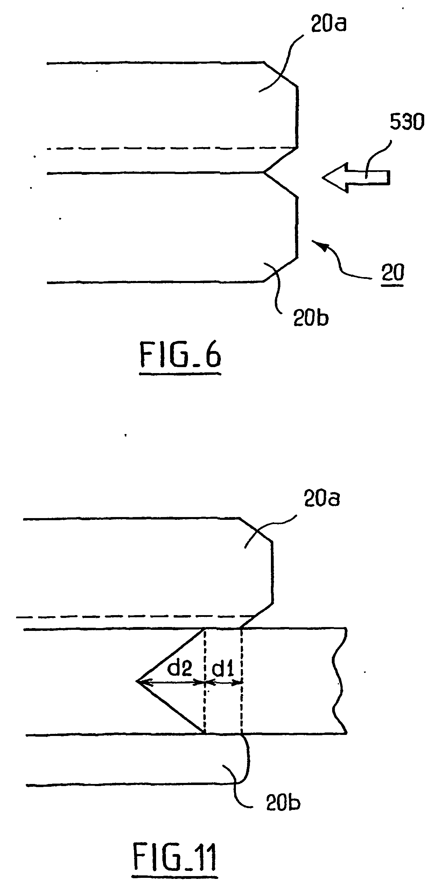

La figure 6 illustre le positionnement de la lame 530 par rapport à l'interface de collage d'un wafer à couper.

Ici encore, les lames des deux moyens de coupe seront prépositionnées sensiblement en regard de cette interface de collage. Et ici encore, après l'attaque de la première lame, le support placé sous le wafer sera escamoté de manière à laisser le wafer libre selon la direction verticale, et à permettre ainsi l'auto-ajustement mentionné ci-dessus.

Les figures 7 et 8 illustrent schématiquement en vue de dessus les deux moyens de coupe, lors des deux phases respectives de la coupe.

Sur la figure 7, la première lame 530 est ainsi amenée par les moyens de déplacement qui lui sont associés au contact du wafer 20, pour attaquer sa paroi et générer une onde de décollement D (dont plusieurs positions successives ont été représentées sur cette figure, et sur la figure 8).

Comme cela apparaît sur la figure, la lame 530 peut avoir une forme en « crissant de lune », présentant un bord d'attaque incurvé pour attaquer le wafer sur une partie continue de sa périphérie.

Un capteur adapté suit la progression de cette onde de décollement D, et/ou tout autre paramètre représentatif du déroulement de cette première phase de coupe.

Lorsque les signaux issus de ce capteur atteignent une valeur seuil prédéterminée, l'activation du deuxième moyen de coupe - et donc de la deuxième phase de coupe - est commandée (voir figure 8).

Comme mentionné ci-dessus, ce déclenchement de la deuxième phase peut également être commandé par des signaux issus de différents capteurs représentatifs de différents aspects du déroulement de la première phase. On pourra dans ce cas utiliser un ou plusieurs signaux composites élaborés à partir des signaux élémentaires des différents capteurs.

Comme illustré sur la figure 8, lors de la deuxième phase, la première lame 530 peut être immobilisée et rester positionnée à son point d'avance maximal atteint lors de la première phase, tandis que le deuxième moyen de coupe est mis en action.

Dans le cas décrit ici, ce deuxième moyen de coupe comprend les deux lames 531 et 532, qui sont déplacées par les moyens respectifs 521 et 522 pour attaquer à leur tour le wafer, selon une trajectoire contrôlée.

Lors de chaque phase, la progression des lames peut être commandée par des signaux issus d'un capteur de force, afin d'éviter de forcer exagérément la pénétration des lames dans le wafer et risquer d'endommager celui-ci.

L'attaque réalisée lors de la deuxième phase permet de continuer à faire progresser l'onde de décollement D dans les meilleures conditions.

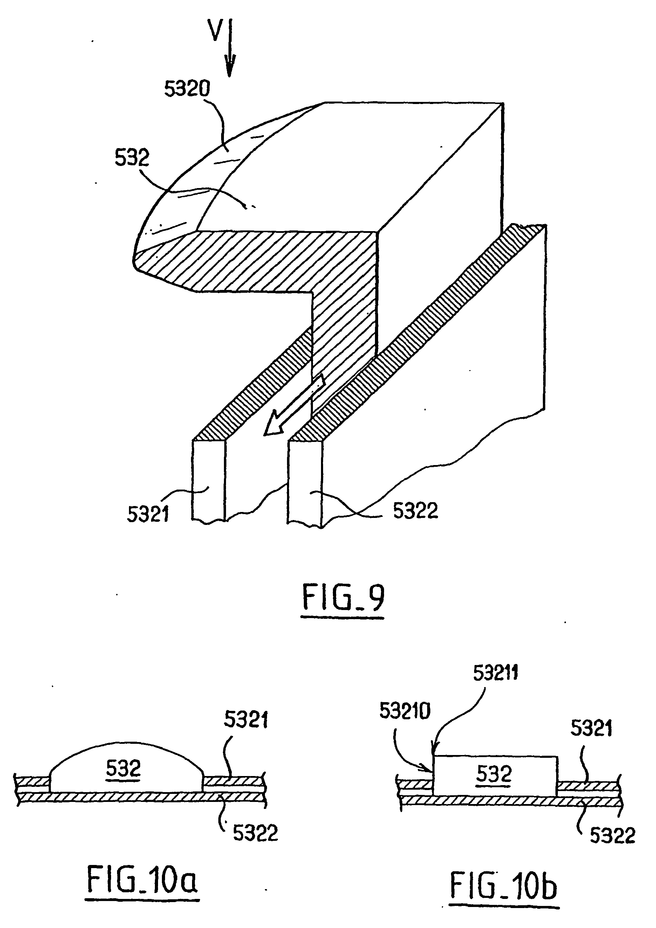

La figure 9 permet de préciser la configuration des lames du deuxième moyen de coupe, ces deux lames étant identiques. On précise également que les deux lames sont déplacées symétriquement par rapport à l'axe A longitudinal du wafer, par leurs moyens de déplacement respectifs qui sont asservis ensemble.

Sur cette figure, la lame 532 coulisse dans deux rails 5321 et 5322 qui guident la trajectoire de la lame.

Dans la configuration de la figure 9 dans laquelle les rails sont verticaux (c'est à dire orientés perpendiculairement au plan de coupe du wafer), cette lame forme en outre un angle droit, de manière à ce que son bord d'attaque soit orienté parallèlement au plan (horizontal) de coupe dans lequel les rails guident la lame.

Et il est également possible que les rails soient disposés l'un au dessus de l'autre, de manière à porter la lame 532 dans le plan de coupe (horizontal). Dans ce cas, les rails sont toumés vers le wafer et la lame 532 ne comporte pas de coude à angle droit.

La lame 532 peut ainsi attaquer tangentiellement le wafer, en le suivant continuellement sur une portion P2 de sa périphérie (la lame 531 pouvant de même attaquer le wafer sur une portion P1 symétrique de sa périphérie).

La figure 9 montre une forme préférée de réalisation de la lame 532, représentée en coupe transversale.

Sur cette figure, la section transversale du bord d'attaque 5320 de la lame a une forme arrondie (ladite section transversale correspondant à la partie hachurée de la lame sur la figure 9), qui permet à cette lame de pénétrer dans le wafer sans risquer de l'endommager.

On précise que cette lame 532 ne pénètre le wafer qu'une fois que les deux parties de wafer ont été préalablement écartées par la première lame 530. La lame 532 n'a ainsi pas de fonction d'initiation du décollement, mais ne fait que propager un décollement initié par la première lame.

Par ailleurs, la lame 532 peut également avoir une forme circulaire en vue de dessus, (une telle vue de dessus correspondant à une vue de la lame 532 selon la direction verticale du haut vers le bas, indiquée par la flèche V sur la figure 9).

Une lame 532 dont le bord d'attaque a une géométrie circulaire en vue de dessus est ainsi représentée sur la figure 10a.

En effet, avec une lame 532 qui aurait en vue de dessus une forme rectangulaire par exemple (ou toute forme présentant en vue de dessus des coins vifs), on risquerait d'attaquer le wafer avec le bord latéral 53210 de cette lame qui se trouve en avant du déplacement de la lame, ou avec le coin latéral 53211 entre ledit bord latéral et la partie de lame qui correspond effectivement au bord d'attaque (voir figure 10b).

Les enseignements du premier mode de réalisation, en particulier ceux relatifs aux wafers à couper, à leurs chanfreins, à la géométrie du bord d'attaque des lames et à l'auto-ajustement de chaque lame et du wafer lui-même lors de l'attaque par chaque lame, ainsi qu'à l'ensemble de cale - donc ici à la cale 510 - sont transposables à ce deuxième mode de réalisation.

Et dans ce deuxième mode de réalisation encore, il est possible de prévoir que la cale 510 est mobile pendant la première phase de coupe, et/ou la deuxième phase, alors que certaines lames sont fixes.

On précise en référence à la figure 11, qui représente schématiquement selon une perspective similaire à celles des figures 3 et 6, et sur laquelle une lame 530 est schématiquement représentée, que si la lame peut lors de la coupe pénétrer d'une profondeur (d1 + d2) qui est de l'ordre de 7 mm, cette profondeur ne correspond pas à la longueur d1 de la zone de contact entre la lame et les parois « internes » du wafer.

En effet, cette longueur de contact n'est typiquement que de l'ordre de 2 mm, alors que la partie en biseau de la pointe du bord d'attaque peut pénétrer d'une longueur d2 de l'ordre de 5 mm, sans provoquer de contact entre la lame et le wafer.

Après le stade initial de pénétration de la lame dans le wafer (lors de laquelle la partie pointue du bord d'attaque est effectivement en contact avec le wafer), seule la partie d'épaisseur constante de la lame est ainsi en contact avec le wafer, sur une longueur de contact d'environ 2 mm. Ce contact permet de maintenir un écartement contrôlé entre les parties du wafer que l'on coupe.

Et la longueur d1 de cette partie correspond sensiblement à la profondeur de la zone d'exclusion du wafer, qui est la zone périphérique superficielle du wafer pouvant comporter certains petits défauts ; ainsi lors de la coupe, après la pénétration initiale, la lame ne coopère-t-elle avec le wafer que dans sa zone d'exclusion (ne risquant pas d'endommager des régions utiles, plus profondes, du wafer).

On peut de la sorte, dans chacun des deux modes de réalisation, constituer des ensembles de coupe de haute précision, fonctionnant de manière entièrement automatique.

Bien entendu, les dispositifs décrits ci-dessus peuvent être mis en oeuvre pour couper des couches de wafer à toutes fins. II est possible de couper des couches pour leur transfert sur un support cible comme mentionné ci-dessus, mais également de couper des couches qui avaient été collées ensemble (par exemple pour reconditionner des couches auxquelles on désire à nouveau avoir accès, en vue de recoller ensuite ces couches après reconditionnement).

## Revendications

1. Dispositif (10, 50) de coupe automatique de haute précision d'une couche de matériau (201) pour l'électronique, l'optique ou l'optoélectronique qui est solidaire d'un substrat source par l'intermédiaire d'une zone fragilisée (202), le substrat source et la couche à couper formant un ensemble à couper, le dispositif comprenant des moyens de coupe (130, 530, 531, 532) ainsi que des moyens (110, 510) de maintien de la position de l'ensemble à couper, les moyens de coupe comprenant une lame (130) pour attaquer l'ensemble à couper, **caractérisé en ce que** les moyens de maintien sont adaptables de manière à maintenir l'ensemble à couper uniquement dans le plan de coupe de la lame une fois que la lame a commencé à attaquer l'ensemble à couper, laissant ledit ensemble à couper libre selon la direction perpendiculaire audit plan de coupe.

2. Dispositif selon la revendication 1 **caractérisé en ce que** les moyens de maintien comprennent une cale.

3. Dispositif selon la revendication 2 **caractérisé en ce que** la cale est fixe.

4. Dispositif selon l'une des revendications 1 à 3 **caractérisé en ce que** la ou les lames est (sont) mobile(s).

5. Dispositif selon l'une des revendications 1 à 4 **caractérisé en ce que** les moyens de maintien sont disposés de manière à recevoir en butée un côté de l'ensemble à couper qui est généralement opposé au côté de l'ensemble à couper qui est attaqué en premier par la lame.

6. Dispositif selon l'une des revendications précédentes **caractérisé en ce que** les moyens de maintien consistent en un ensemble de cale.

7. Dispositif selon la revendication précédente **caractérisé en ce que** les moyens de maintien consistent en une cale unique (110, 510).

8. Dispositif selon l'une des revendications précédentes **caractérisé en ce que** la lame est associée à des moyens de réglage de position de lame selon la direction perpendiculaire au plan de coupe, permettant de positionner la lame à proximité de la zone fragilisée de l'ensemble à couper.

9. Dispositif selon l'une des revendications précédentes **caractérisé en ce que** la lame présente un angle en pointe de l'ordre de 60°.

10. Dispositif selon l'une des revendications précédentes **caractérisé en ce que** la lame est montée sur des moyens de déplacement automatique.

11. Dispositif selon la revendication précédente **caractérisé en ce que** lesdits moyens de déplacement automatique assurent une translation contrôlée de la lame dans le plan de coupe.

12. Dispositif selon la revendication précédente **caractérisé en ce que** ladite translation contrôlée est une translation uniforme.

13. Dispositif selon l'une des revendications précédentes **caractérisé en ce que** le bord d'attaque de la lame a un contour circulaire correspondant au contour de l'ensemble à couper.

14. Dispositif selon la revendication précédente **caractérisé en ce que** le bord d'attaque de la lame couvre le quart de la périphérie de l'ensemble à couper.

15. Dispositif selon l'une des revendications précédentes, **caractérisé en ce que** les moyens de coupe comprennent un premier moyen de coupe (530), et un deuxième moyen de coupe (531, 532).

16. Dispositif selon la revendication précédente **caractérisé en ce que** le dispositif comprend également un capteur apte à acquérir un paramètre représentatif du déroulement de la coupe par le premier moyen de coupe, et des moyens pour déclencher la mise en oeuvre du deuxième moyen de coupe lorsque ledit paramètre atteint une valeur prédéterminée.

17. Dispositif selon la revendication précédente **caractérisé en ce que** ledit paramètre est lié à une mesure de l'écartement entre les parties du wafer à couper.

18. Dispositif selon l'une des trois revendications précédentes, **caractérisé en ce que** le premier moyen de coupe comprend une lame (530), et le deuxième moyen de coupe comprend deux lames (531, 532) agencées symétriquement par rapport à l'ensemble à couper.

19. Dispositif selon la revendication précédente **caractérisé en ce** chaque lame du deuxième moyen de coupe est montée à déplacement sur des moyens de déplacement (5321, 5322) et le bord d'attaque de chaque lame est orienté de manière à attaquer l'ensemble à couper tangentiellement sur une portion de sa périphérie.

20. Procédé de coupe automatique de haute précision d'une couche de matériau qui est solidaire d'un substrat source par l'intermédiaire d'une zone fragilisée, le substrat source et la couche à couper formant un ensemble à couper, le procédé comprenant :
• le positionnement de l'ensemble à couper par rapport à des moyens de maintien,
• la coupe de la couche par au moins une lame des moyens de coupe associée à des moyens de déplacement,
• l'engagement de la lame dans une cavité de l'ensemble à couper, ladite cavité se trouvant à proximité de la zone fragilisée,
**caractérisé en ce que** la coupe est effectuée tandis que les moyens de maintien bloquent l'ensemble à couper dans le plan de coupe, et le procédé comprend l'auto-ajustement, selon la direction perpendiculaire au plan de coupe, des positions relatives de l'ensemble à couper et de la lame lors de l'engagement de la lame et de l'ensemble à couper, par coopération de la partie tranchante de la lame et de la section concave de la cavité.

21. Procédé selon la revendication précédente, **caractérisé en ce que** ladite cavité est une cavité de forme générale annulaire.

22. Procédé selon l'une des deux revendications précédentes, **caractérisé en ce qu'**on suit l'onde de décollement de la couche à couper par analyse de la lumière transmise au travers des faces principales de l'ensemble à couper.

23. Procédé selon la revendication précédente, **caractérisé en ce que** les mouvements des moyens de déplacement de la lame sont asservis à l'observation du décollement de la couche à couper.

24. Procédé selon l'une des revendications précédentes **caractérisé en ce que** l'on recueille au moins un paramètre représentatif du déroulement de la coupe lors d'une première phase de coupe réalisée par un premier moyen de coupe, et on commande en fonction de la valeur de ce paramètre le déclenchement d'une deuxième phase de coupe réalisée par un deuxième moyen de coupe.

25. Procédé selon l'une des cinq revendications précédentes, **caractérisé en ce que** le premier moyen de coupe est une lame (530) attaquant l'ensemble à couper en un premier endroit, et le deuxième moyen de coupe attaque l'ensemble à couper à distance de la partie dudit ensemble recevant l'attaque du premier moyen de coupe.

26. Procédé selon la revendication précédente, **caractérisé en ce que** le deuxième moyen de coupe comprend deux lames situées de part et d'autre de l'ensemble à couper, et déplacées symétriquement par rapport à cet ensemble.

## Patentansprüche

1. Vorrichtung (10, 50) zum automatischen Schneiden mit hoher Präzision einer Materialschicht (201) für die Elektronik, Optik oder Optoelektronik, die über eine geschwächte Zone (202) fest mit einem Basissubstrat verbunden ist, wobei das Basissubstrat und die abzuschneidende Schicht eine zu schneidende Einheit bilden, wobei die Vorrichtung Schneidemittel (130, 530, 531, 532) und Mittel (110, 510) zum Halten der Position der zu schneidenden Einheit umfaßt, wobei die Schneidemittel eine Klinge (130) zum bearbeiten der zu schneidenden Einheit umfassen, **dadurch gekennzeichnet, daß** die Haltemittel derart angepaßt werden können, daß, nachdem die Klinge begonnen hat die zu schneidende Einheit zu bearbeiten, die zu schneidende Einheit nur in der Schneideebene der Klinge gehalten wird, wobei die zu schneidende Einheit in der Richtung senkrecht zur Schneideebene frei beweglich bleibt.

2. Vorrichtung nach Anspruch 1, **dadurch gekennzeichnet, daß** die Haltemittel einen Anschlagklotz umfassen.

3. Vorrichtung nach Anspruch 2, **dadurch gekennzeichnet, daß** der Anschlagklotz feststehend ist.

4. Vorrichtung nach einem der Ansprüche 1 bis 3, **dadurch gekennzeichnet, daß** die eine oder mehreren Klingen beweglich sind.

5. Vorrichtung nach einem der Ansprüche 1 bis 4, **dadurch gekennzeichnet, daß** die Haltemittel so angeordnet sind, daß an ihnen eine Seite der zu schneidenden Einheit anschlägt, wobei diese im allgemeinen der Seite der zu schneidenden Einheit, die zuerst von der Klinge bearbeitet wird, gegenüberliegt.

6. Vorrichtung nach einem der vorhergehenden Ansprüche, **dadurch gekennzeichnet, daß** die Haltemittel aus einer Anschlagklotzeinheit bestehen.

7. Vorrichtung nach dem vorhergehenden Anspruch, **dadurch gekennzeichnet, daß** die Haltemittel aus einem einzelnen Anschlagklotz (110, 510) bestehen.

8. Vorrichtung nach einem der vorhergehenden Ansprüche, **dadurch gekennzeichnet, daß** die Klinge mit Mitteln zum Einstellen der Position der Klinge in der Richtung senkrecht zur Schneideebene verbunden ist, die es gestatten, die Klinge in der Nähe der geschwächten Zone der zu schneidenden Einheit zu positionieren.

9. Vorrichtung nach einem der vorhergehenden Ansprüche, **dadurch gekennzeichnet, daß** die Klinge einen Spitzenwinkel in der Größenordnung von 60° aufweist.

10. Vorrichtung nach einem der vorhergehenden Ansprüche, **dadurch gekennzeichnet, daß** die Klinge auf Mitteln zum automatischen Bewegen montiert ist.

11. Vorrichtung nach dem vorhergehenden Anspruch, **dadurch gekennzeichnet, daß** die Mittel zum automatischen Bewegen eine gesteuerte Verschiebung der Klinge in der Schneideebene bereitstellen.

12. Vorrichtung nach dem vorhergehenden Anspruch, **dadurch gekennzeichnet, daß** die gesteuerte Verschiebung eine gleichförmige Verschiebung ist.

13. Vorrichtung nach einem der vorhergehenden Ansprüche, **dadurch gekennzeichnet, daß** der Arbeitsrand der Klinge eine kreisförmige Kontur hat, die der Kontur der zu schneidenden Einheit entspricht.

14. Vorrichtung nach dem vorhergehenden Anspruch, **dadurch gekennzeichnet, daß** der Arbeitsrand der Klinge ein Viertel des Umfangs der zu schneidenden Einheit abdeckt.

15. Vorrichtung nach einem der vorhergehenden Ansprüche, **dadurch gekennzeichnet, daß** die Schneidemittel ein erstes Schneidemittel (530) und ein zweites Schneidemittel (531, 532) umfassen.

16. Vorrichtung nach dem vorhergehenden Anspruch, **dadurch gekennzeichnet, daß** die Vorrichtung auch einen Sensor umfaßt, der dafür eingerichtet ist, einen Parameter zu erfassen, der das Fortschreiten des Schneidevorgangs des ersten Schneidemittels repräsentiert, sowie Mittel zum Auslösen des Einsatzes des zweiten Schneidemittels, wenn der Parameter einen vorbestimmten Wert erreicht hat.

17. Vorrichtung nach dem vorhergehenden Anspruch, **dadurch gekennzeichnet, daß** der Parameter mit einer Messung des Abstands zwischen den auseinanderzuschneidenden Teilen des Wafers verbunden ist.

18. Vorrichtung nach einem der drei vorhergehenden Ansprüche, **dadurch gekennzeichnet, daß** das erste Schneidemittel eine Klinge (530) umfaßt und das zweite Schneidemittel zwei Klingen (531, 532) umfaßt, die in Bezug auf die zu schneidende Einheit symmetrisch angeordnet sind.

19. Vorrichtung nach dem vorhergehenden Anspruch, **dadurch gekennzeichnet, daß** jede Klinge des zweiten Schneidemittels beweglich auf Bewegungsmitteln (5321, 5322) angebracht ist und der Arbeitsrand jeder Klinge derart orientiert ist, daß die zu schneidende Einheit auf einem Abschnitt ihres Umfangs tangential bearbeitet wird.

20. Verfahren zum automatischen Schneiden mit hoher Präzision einer Materialschicht, die über eine geschwächte Zone fest mit einem Basissubstrat verbunden ist, wobei das Basissubstrat und die abzuschneidende Schicht eine zu schneidende Einheit bilden, wobei das Verfahren folgendes umfaßt:
• die Positionierung der zu schneidenden Einheit gegenüber Haltemitteln,
• das Schneiden der Schicht durch wenigstens eine Klinge der Schneidemittel, die mit Bewegungsmitteln verbunden ist,
• das Eingreifen der Klinge in eine Höhlung der zu schneidenden Einheit, wobei die Höhlung sich in der Nähe der geschwächten Zone befindet,
**dadurch gekennzeichnet, daß** das Schneiden durchgeführt wird während die Haltemittel die zu scheidende Einheit in der Schneideebene festhalten und das Verfahren folgendes umfaßt: das Selbstjustieren der Relativpositionen der zu schneidenden Einheit und der Klinge in der Richtung senkrecht zur Schneideebene während des Eingreifens der Klinge und der zu schneidenden Einheit, durch ein Zusammenwirken des schneidenden Teils der Klinge und des konkaven Querschnitts der Höhlung.

21. Verfahren nach dem vorhergehenden Anspruch, **dadurch gekennzeichnet, daß** die Höhlung eine allgemein ringförmige Höhlung ist.

22. Verfahren nach einem der zwei vorhergehenden Ansprüche, **dadurch gekennzeichnet, daß** die Ablösewelle der abzuschneidenden Schicht durch die Analyse von Licht verfolgt wird, das durch die Hauptflächen der zu schneidenden Einheit geworfen wird.

23. Verfahren nach dem vorhergehenden Anspruch, **dadurch gekennzeichnet, daß** die Bewegungen der Mittel zur Bewegung der Klinge durch die Beobachtung des Ablösens der zu schneidenden Schicht geregelt werden.

24. Verfahren nach einem der vorhergehenden Ansprüche, **dadurch gekennzeichnet, daß** wenigstens ein Parameter erfaßt wird, der das Fortschreiten des Schneidevorgangs während einer ersten Schneidephase repräsentiert, die durch ein erstes Schneidemittel durchgeführt wird, und in Abhängigkeit des Wertes dieses Parameters das Auslösen einer zweiten Schneidephase gesteuert wird, die von einem zweiten Schneidemittel durchgeführt wird.

25. Verfahren nach einem der fünf vorhergehenden Ansprüche, **dadurch gekennzeichnet, daß** das erste Schneidemittel eine Klinge (530) ist, die die zu schneidende Einheit an einer ersten Stelle bearbeitet, und das zweite Schneidemittel die zu schneidende Einheit in einem Abstand zu dem Abschnitt der Einheit bearbeitet, an dem die Bearbeitung durch das erste Schneidemittel erfolgt.

26. Verfahren nach dem vorhergehenden Anspruch, **dadurch gekennzeichnet, daß** das zweite Schneidemittel zwei Klingen umfaßt, die auf beiden Seiten der zu schneidenden Einheit angeordnet sind und die in Bezug auf diese Einheit symmetrisch bewegt werden.

## Claims

1. Device (10, 50) for automatic high-precision cutting of a layer of material (201) for use in electronics, optics and optoelectronics, fixed to a source substrate by means of a weakened area (202), the source substrate and the layer to be cut forming an assembly to be cut, the device comprising cutting means (130, 530, 531, 532) and means (110, 510) for maintaining the position of the assembly to be cut, the cutting means comprising a blade (130) to attack the assembly to be cut, **characterised in that** the maintaining means can be adapted so as to maintain the assembly to be cut in the cutting plane of the blade once the blade has started to attack the assembly to be cut, leaving the said assembly to be cut free along the direction perpendicular to the said cut plane.

2. Device according to claim 1, **characterised in that** the maintaining means comprise a shim.

3. Device according to claim 2, **characterised in that** the shim is fixed.

4. Device according to one of claims 1 to 3, **characterised in that** the blade(s) is (are) mobile.

5. Device according to one of claims 1 to 4, **characterised in that** the maintaining means are arranged so that one side of the assembly to be cut stops in contact with these maintaining means, usually the side opposite the side of the assembly to be cut and attacked first by the blade.

6. Device according to one of the above claims, **characterised in that** the maintaining means consist of a set of shims.

7. Device according to the above claim, **characterised in that** the maintaining means consist of a single shim (110, 510).

8. Device according to one of the above claims, **characterised in that** the blade is used with blade position adjustment means along the direction perpendicular to the cutting plane so that the blade can be placed close to the weakened area of the assembly to be cut.

9. Device according to one of the above claims, **characterised in that** the blade has a vertex angle of the order of 60°.

10. Device according to one of the above claims, **characterised in that** the blade is mounted on automatic displacement means.

11. Device according to the above claim, **characterised in that** the said automatic displacement means control translation of the blade in the cutting plane.

12. Device according to the above claim, **characterised in that** the said controlled translation is a uniform translation.

13. Device according to one of the above claims, **characterised in that** the leading edge of the blade has a circular contour corresponding to the contour of the assembly to be cut.

14. Device according to the above claim, **characterised in that** the blade leading edge covers a quarter of the periphery of the assembly to be cut.

15. Device according to one of the above claims, **characterised in that** the cutting means comprise a first cutting means (530) and a second cutting means (531, 532).

16. Device according to the above claim, **characterised in that** it also comprises a sensor capable of acquiring a parameter representing progress with the cutting operation by the first cutting means, and means of triggering use of the second cutting means when the said parameter reaches a predetermined value.

17. Device according to the above claim, **characterised in that** the said parameter is related to a measurement of the spacing between the parts of the wafer to be cut.

18. Device according to one of the above three claims, **characterised in that** the first cutting means comprises a blade (530), and the second cutting means comprises two blades (531, 532) arranged symmetrically with respect to the assembly to be cut.

19. Device according to the above claim, **characterised in that** each blade in the second cutting means is mounted free to displace on displacement means (5321, 5322) and the leading edge of each blade is oriented so as to attack the assembly to be cut tangentially on a portion of its periphery.

20. Process for automatic high-precision cutting of a layer of material fixed to a source substrate by means of a weakened area, the source substrate and the layer to be cut forming an assembly to be cut, the process comprising:
- positioning of the assembly to be cut with respect to maintaining means,
- cutting of the layer by at least one blade of the cutting means associated with displacement means,
- engagement of the blade into a cavity of the assembly to be cut, the said cavity being located close to the weakened area,
**characterised in that** the cut is made while the maintaining means maintain the position of the assembly to be cut in the cutting plane, and the process includes self-adjustment of the relative positions of the assembly to be cut and the blade along the direction perpendicular to the cutting plane when the blade and the assembly to be cut are engaged, by cooperation between the cutting part of the blade and the concave section of the cavity.

21. Process according to the above claim, **characterised in that** the said cavity is an approximately annular-shaped cavity.

22. Process according to one of the above two claims, **characterised in that** the separation wave of the layer to be cut is monitored by analysing light transmitted through the principal faces of the assembly to be cut.

23. Process according to the above claim, **characterised in that** the movements of the blade displacement means are slaved to observation of the separation of the layer to be cut.

24. Process according to one of the above claims, **characterised in that** at least one parameter representative of progress with the cutting operation is collected during a first cutting phase carried out by a first cutting means, and a second cutting phase made by a second cutting means is controlled as a function of the value of this parameter.

25. Process according to one of the above five claims, **characterised in that** the first cutting means is a blade (530) attacking the assembly to be cut at a first location, and the second cutting means attacks the assembly to be cut at a distance from the part of the said assembly attacked by the first cutting means.

26. Process according to the above claim, **characterised in that** the second cutting means comprises two blades on each side of the assembly to be cut, and moved symmetrically with respect to this assembly.
